# EUROPEAN PATENT SPECIFICATION

(11) **EP 2 805 344 B1**
(45) Date of publication and mention of the grant of the patent: **17.04.2024**
(21) Application number: 13701364.5
(22) Date of filing: 18.01.2013
(51) Int. Cl.: H01H 33/02, H01H 71/12, G01R 15/14, H01H 83/10, H01H 83/12

(54) **A SENSING DEVICE FOR LOW-, MEDIUM- OR HIGH VOLTAGE SWITCHING DEVICES**
ERFASSUNGSVORRICHTUNG FÜR NIEDER-, MITTEL- ODER HOCHSPANNUNGSSCHALTVORRICHTUNGEN
DISPOSITIF DE DÉTECTION POUR DISPOSITIFS DE COMMUTATION À BASSE, MOYENNE OU HAUTE TENSION

(30) Priority: 19.01.2012 EP 12000298
(43) Date of publication of application: 26.11.2014
(73) Proprietor: ABB Schweiz AG, 5400 Baden (CH)
(72) Inventor: JAVORA, Radek, 624 00 Brno (CZ); RASCHKA, David, 664 91 Ivancice (CZ)
(74) Representative: Maiwald GmbH
(86) International application number: PCT/EP2013/000145
(87) International publication number: WO 2013/107647

(56) References cited:
- EP-A2- 0 510 311
- EP-A2- 0 851 442
- WO-A1-2008/151937
- WO-A2-2012/056304
- US-A- 5 585 611

## Description

The invention concerns to a voltage and/or current sensing device for low-, medium- or high voltage switching devices connected to an upper and/or a lower terminal of the switching device and the ground potential.

Presently, only single current or voltage sensing devices exist for the use described in the voltage and/or current sensing for low-, medium- or high voltage switching devices connected to an upper and/or a lower terminal of the switching device and the ground potential.

In case of sensing voltage and/or current on a disconnecting or switching device, two voltage measurements need to be installed at both ends of said switching device in order to cover both, connected and disconnected state of the device. It is sufficient to sense current only at one end of the device as the current is flowing only in case of connected state of the switching device.
WO2008/151937A1 relates to a switching pole for a high-voltage network, having a switching unit disposed in the switching pole housing thereof, the switching unit comprising a fixed and movable contact, wherein an input connector on the fixed contact side is connected to an output connector on the movable contact side in an electrically conductive manner in the switched-on position of the switching unit. In order to be able to simultaneously connect a current and a voltage sensor to one of the connectors while maintaining breakdown safety, an arrangement of the current and voltage sensors at a circumferential distance from each other on the circumferential wall of the switching pole housing is provided, which prevents partial discharges.
EP0510311A2 describes that the current and voltage transformer is intended for a metal-encapsulated, gas-insulated high-voltage installation. It has an annular supporting body which can be fixed inside the metal encapsulation and is used for holding a current sensor and a voltage sensor. The current sensor, held on the supporting body, is constructed as a toroidally wound coil and the voltage sensor, held on the supporting body, is constructed as a hollow-cylindrical measurement electrode. After fitment in the installation, the coil and measurement electrode concentrically surround a current conductor of the installation. This current and voltage transformer is intended to have small dimensions and is intended to be capable of fitment without problems at any point in the installation. This is achieved in that the coil is wound in the manner of a Rogowski coil on an annular core of non-ferromagnetic material, of essentially rectangular cross-section when cut in the axial direction, having a small radial dimension in comparison with the radius of the core and with its axial extent, and is arranged in a hollow-cylindrical space in the supporting body, which space is shielded against electric fields and whose boundary wall providing the electrical shielding is connected, after fitment, to the potential of the metal encapsulation.

Traditional approach of sensing current and voltage over switching devices uses one separate current sensing device and two separate phase-to-ground voltage sensing devices located each on different sides of the switching device.

So it is the object of the invention, to present a constructively enhanced measuring device with high performance for the use in switching devices.

This is realized by the invention, that the sensing device comprises a first voltage sensing part, second voltage sensing part and a current sensing part arranged in a single housing in a way that output wire from the first voltage sensing part, sensing voltage at an upper terminal of the switching device, is located close to the current sensing part.
The invention and its scope of protection are defined in appended claim 1, where a sensing device for a low-voltage, medium-voltage or high voltage switching device, for connection to a terminal of such a switching device and to ground potential is defined.
Embodiments of the invention are defined in the appended dependent claims.

So the invention is, to present a single measuring device that enables to measure voltages on both ends of devices such as circuit breaker or disconnector. Special construction of such device allows combination of two phase-to-ground voltage measurements and current measurement into a single design.

Further embodiments are given as follows.

An advantageous embodiment is, that the second voltage sensing part is located between the current sensing part and lower terminal of the switching device.

A further advantageous detail is, that the second voltage sensing part is located in parallel to the current sensing part, and is connected between the lower terminal and the ground potential of the switching device.

A first advantageous alternative according to the type of voltage sensor is, that at least the first of the voltage sensing parts, located at the upper terminal is applied with, or arranged as resistive divider. This includes also, that both voltage sensing parts can be applied with or arranged as resistive divider.

A second alternative to that is, that the first voltage sensing part, located at the upper terminal is applied with, or arranged as resistive divider, and the second voltage sensing part located at the lower terminal is applied with, or arranged as a capacitive divider.

The use of low-power current and voltage sensing technologies as current and voltage sensing parts is advantageous.

Furthermore advantageous is, that current transformer for current sensing part and/or voltage transformer for at least one voltage sensing part are applied.

One embodiment of practical value is, that the sensing device contains of two voltage sensing parts.

For several applications it is also advantageous, that the sensing device contains one voltage sensing part and one current sensing part.

The device can be used alternatively. First alternative is, that the sensing device is applied for single phase application.

Fortunately the device can also be applied for multiple phase application, in that way, that each phase is applied with one independent sensing device.

Advantageous is the application, that in the use of the sensing device in switchgears with circuit breaker or vacuum circuit breaker, the sensing device is in the near of a pole part, which contains the vacuum circuit breaker. For this application or in general, the invention related sensing device is very compact, and so with high practical use, in switchgear arrangements which should be compact.

According to a compact arrangement an advantageous embodiment is, that the sensing device is positioned in parallel to the circuit breaker or pole part long axis.

Furthermore the sensing device has a high practical importance for the use in disconnectors, in order to ensure also security effects.

Several examples and advantageous embodiments of the invention are shown in the figures and disclosed as follows.
Figure 1 : double voltage switching device, wherein only the bottom part of Fig. 1 shows a sensing device according to the invention
Figure 2 : double voltage sensing device with current sensing
Figure 3 : compact sensing device
Figure 4 : Embodiment in use with medium voltage circuit breaker
Figure 5 : further embodiment, which is not according to the invention
Figure 6 : a further alternative arrangement of the sensors

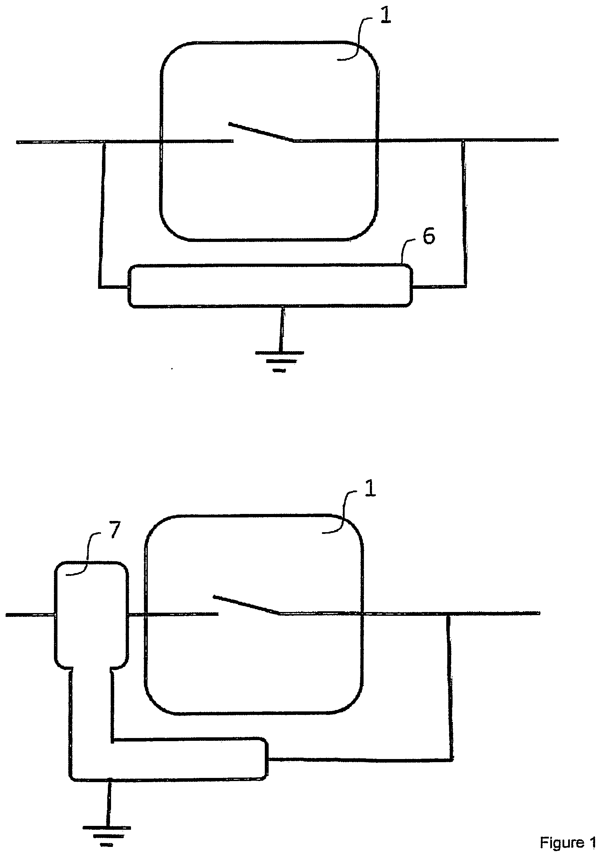

In order to eliminate the need for several sensing devices, reduce the installation costs and simplify assembly, it is proposed to integrate all sensing requirements into a single device. Such device might be either single phase device or even multiphase device. In following, only the single phase device for sensing will be described. Concept and shape of such device is shown in Fig. 1. Fig. 1 shows a double voltage sensing device 6 over switching device 1. It is also possible to implement a current sensing integrated inside of the same device, see bottom part of figure 1, which shows a double voltage sensing device with current sensing integrated 7.

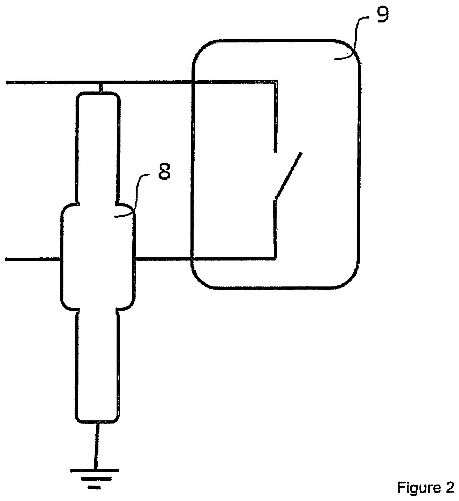

Sensing of current and voltage could be realized by different means, e.g. by conventional current and voltage instrument transformers or low-power current and voltage sensors could be used. Biggest advantage and lowest size of such solution could be preferably achieved by low-power sensors. Preferred design that follow the same idea as in Fig. 1 (bottom) and that is much more size optimized is described in Fig. 2. In this case the switching device is a circuit breaker that has contact arms located above each other. Such concept has less space available between the contact arms and sensing solution could be then fully optimized. Fig. 2 with a double voltage sensing device with current sensing 8 used for circuit breaker 9 solution with parallel contact arms.

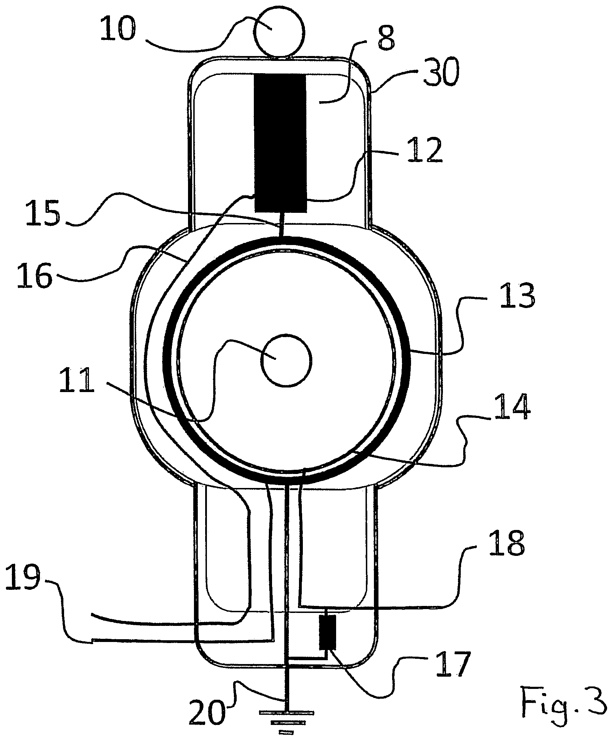

Both phase-to-ground voltage sensing parts of the device 8 needs to connect one of their end to the line voltage to be sensed and the other one to the ground potential. In order to achieve the best electrical parameters, voltage distribution between the contact arms and fully optimized space occupied, following design of the sensing device 8, which is a current sensor, integrated with double voltage sensing device, is preferred, see Fig.3 .

Fig. 3 shows a construction of double voltage sensing device with integrated current sensing Fig. 3 shows a sensing device 8 comprising of first voltage sensing device 12, preferably a resistive voltage divider, current sensing device 13, preferably a low-power current sensor and a second voltage sensing device 14, preferably a capacitive voltage divider. Line voltage to be sensed is located at upper terminal 10 of the circuit breaker 9 and at lower terminal 11.
First voltage sensing device 12 has ground connection 15 connected to the grounded shield of current sensing device 13. Output wire 16 of the first voltage sensing device 12 is located close to the current sensing device 13, but being insulated from each other. Output from current sensing device 13 is done by means of two output wires 19. Main part of a second voltage sensing device 14 is located within a current sensing device 13, but secondary impedance 17 of a second voltage sensing device 14 is located outside. Output of a second voltage sensing device 14 is realized by output wire 18.
All outputs 16, 18 and 19 from sensing elements are insulated from each other. They might have a separate output wire or cable each, or they all could be also integrated into one output cable. One end of both voltage sensing devices 12 and 14 has to be connected to the ground terminal 20. The sensing device is electrically shielded, and the shield is connected to the grounding terminal 20 as well.

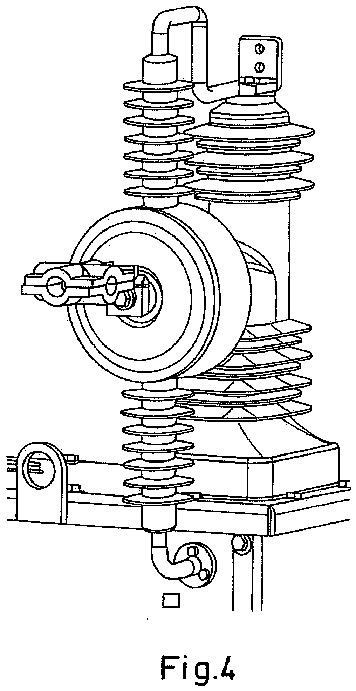

Figure 4 shows the compact and near placement of the invention related switching device in parallel to the long axis of a typical medium voltage pole part.

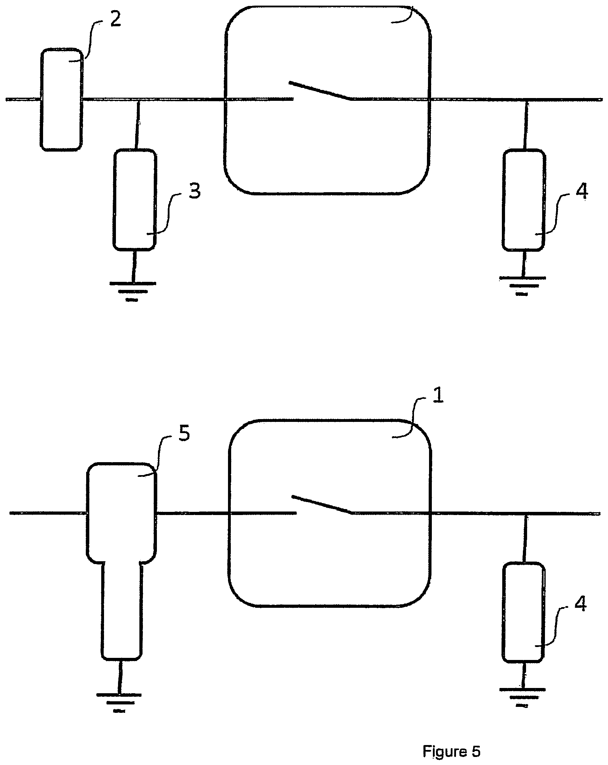

Figure 5 shows an embodiment which does not form part of the invention. Top Part of Figure 5 shows a separate current 2 and voltage 3, 4 sensing devices over the switching device 1.
Such device could be either single-phase device or the same approach could be applied in case of three-phase device as well. In that case, the same arrangement is done in all three phases.
In some cases there exists solutions using combined sensors on one side, integrating current and voltage measurement on one side into a single one-phase device. Voltage sensing on the other side requires a separate device.

Bottom part of figure 5 shows a Combined current and voltage sensing device 5, which is a combined current and voltage sensing device on one side and single voltage sensing device 4 on the other side of switching device 1.

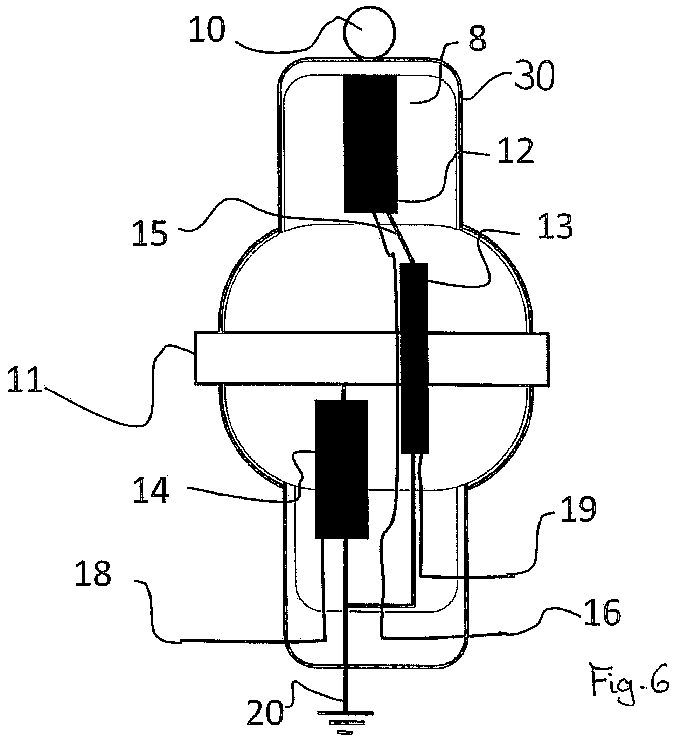

Figure 6 shows a further detailed alternative concerning to the arrangement of the several sensors in the housing 30.
The second voltage sensing part 14 is located in parallel to the current sensing part 13 and it is connected between the lower terminal 11 and the ground terminal 20 of the switching device.

### Position numbers

1: switching device
2 : current sensor
3 : voltage sensor
4 : voltage sensor
5 : combined current and voltage sensing device
6 : double voltage sensing device
7 : current sensor integrated with double voltage sensing device
8 : current sensor integrated with double voltage sensing device
9 : circuit breaker
10 : upper terminal
11: lower terminal
12 : voltage sensing device
13 : current sensing device
14 : voltage sensing device
15 : ground connection
16 : output of sensing device
17 : secondary impedance
18 : output of sensing device
19 : output of sensing device
20 : ground terminal
30 : housing

## Claims

1. A sensing device for a low-voltage, medium-voltage or high voltage switching device, for connection to a terminal of such a switching device and to ground potential, the sensing device comprising:
a first voltage sensing part (12); and
a second voltage sensing part (14);
wherein a current sensing part (13) is arranged with the first voltage sensing part and the second voltage sensing part in a single common sensing device housing (30),
wherein an end of the first voltage sensing part, an end of the second voltage sensing part, and an electrical shield of the current sensing part (13) are connected to a ground terminal (20);
wherein an output (16) from the first voltage sensing part (12) for sensing voltage at an upper terminal (10) of the switching device extends within the sensing device housing (30) and is insulated from the current sensing part (13);
wherein an output (18) from the second voltage sensing part (14) for sensing voltage at a lower terminal (11) of the switching device extends within the sensing device housing (30);
wherein the output (16) from the first voltage sensing part (12), the output (18) from the second voltage sensing part (14), and an output (19) from the current sensing part (13) are insulated from each other; and
wherein the switching device and the sensing device comprise different devices, **characterised in that** the sensing device housing (30) is separate to a housing for the switching device.

2. The sensing device according to claim 1, wherein the second voltage sensing part is located between the current sensing part and a connection for a lower terminal of the switching device.

3. The sensing device according to claim 1, wherein the second voltage sensing part is located in parallel to the current sensing part, for connection between a lower terminal and ground potential of the switching device.

4. The sensing device according to any of claims 1-3, wherein at least the first of the voltage sensing parts, located at the upper terminal is a resistive divider.

5. The sensing device according to claim 1, wherein the first voltage sensing part, located at the upper terminal is applied with, or arranged as resistive divider, and the second voltage sensing part located at the lower terminal is a capacitive divider.

6. The sensing device according to any of claims 1-5, comprising:
low-power current and voltage sensing technologies as current and voltage sensing parts.

7. The sensing device according to any of claims 1-5, comprising:
a current transformer for a current sensing part and/or a voltage transformer for at least one voltage sensing part.

8. The sensing device according to any of claims 1-5, wherein the sensing device is configured for single phase detection.

9. A sensing device configured for three phase detection, each phase being applied with one independent sensing device according to claim 1.

10. The sensing device according to any of claims 1-9, in combination with a switchgear, with a circuit breaker, or a vacuum circuit breaker wherein the sensing device is positioned near a pole part which contains the circuit breaker or the vacuum circuit breaker.

11. The combination according to claim 10, wherein the sensing device is positioned in parallel to the circuit breaker or circuit breaker pole part long axis.

## Patentansprüche

1. Erfassungsvorrichtung für eine Niederspannungs-, Mittelspannungs- oder Hochspannungs-Schaltvorrichtung zur Verbindung mit einem Anschluss einer solchen Schaltvorrichtung und an das Massepotenzial, wobei die Erfassungsvorrichtung umfasst:
ein erstes Spannungserfassungsteil (12); und
ein zweites Spannungserfassungsteil (14);
wobei ein Stromerfassungsteil (13) mit dem ersten Spannungserfassungsteil und dem zweiten Spannungserfassungsteil in einem einzelnen gemeinsamen Erfassungsvorrichtungsgehäuse (30) angeordnet ist,
wobei ein Ende des ersten Spannungserfassungsteils, ein Ende des zweiten Spannungserfassungsteils und eine elektrische Abschirmung des Stromerfassungsteils (13) mit einem Masseanschluss (20) verbunden sind;
wobei ein Ausgang (16) von dem ersten Spannungserfassungsteil (12) zum Erfassen der Spannung an einem oberen Anschluss (10) der Schaltvorrichtung sich innerhalb des Erfassungsvorrichtungsgehäuses (30) erstreckt und von dem Stromerfassungsteil (13) isoliert ist;
wobei sich ein Ausgang (18) von dem zweiten Spannungserfassungsteil (14) zum Erfassen der Spannung an einem unteren Anschluss (11) der Schaltvorrichtung innerhalb des Erfassungsvorrichtungsgehäuses (30) erstreckt;
wobei der Ausgang (16) von dem ersten Spannungserfassungsteil (12), der Ausgang (18) von dem zweiten Spannungserfassungsteil (14) und ein Ausgang (19) von dem Stromerfassungsteil (13) voneinander isoliert sind; und
wobei die Schaltvorrichtung und die Erfassungsvorrichtung unterschiedliche Vorrichtungen umfassen, **dadurch gekennzeichnet, dass** das Erfassungsvorrichtungsgehäuse (30) von einem Gehäuse für die Schaltvorrichtung getrennt ist.

2. Erfassungsvorrichtung nach Anspruch 1, wobei das zweite Spannungserfassungsteil zwischen dem Stromerfassungsteil und einer Verbindung für einen unteren Anschluss der Schaltvorrichtung liegt.

3. Erfassungsvorrichtung nach Anspruch 1, wobei das zweite Spannungserfassungsteil parallel zum Stromerfassungsteil für eine Verbindung zwischen einem unteren Anschluss und dem Massepotenzial der Schaltvorrichtung liegt.

4. Erfassungsvorrichtung nach einem der Ansprüche 1-3, wobei zumindest das erste der Spannungserfassungsteile, das am oberen Anschluss liegt, ein Widerstandsteiler ist.

5. Erfassungsvorrichtung nach Anspruch 1, wobei der erste, am oberen Anschluss liegende Spannungserfassungsteil als Widerstandsteiler ausgeführt oder angeordnet ist, und der zweite, am unteren Anschluss liegende Spannungserfassungsteil ein kapazitiver Teiler ist.

6. Erfassungsvorrichtung nach einem der Ansprüche 1-5, die umfasst:
leistungsarme Strom- und Spannungserfassungstechnologien als Strom- und Spannungserfassungsteile.

7. Erfassungsvorrichtung nach einem der Ansprüche 1-5, die umfasst:
einen Stromwandler für ein Stromerfassungsteil und/oder einen Spannungswandler für zumindest ein Spannungserfassungsteil.

8. Erfassungsvorrichtung nach einem der Ansprüche 1-5, wobei die Erfassungsvorrichtung für eine einphasige Detektion ausgelegt ist.

9. Erfassungsvorrichtung, die für eine dreiphasige Detektion ausgelegt ist, wobei jede Phase mit einer unabhängigen Erfassungsvorrichtung nach Anspruch 1 versehen ist.

10. Erfassungsvorrichtung nach einem der Ansprüche 1-9 in Kombination mit einer Schaltanlage, mit einem Leistungsschalter oder einem Vakuumleistungsschalter, wobei die Erfassungsvorrichtung in der Nähe eines Polteils angeordnet ist, das den Leistungsschalter oder den Vakuumleistungsschalter enthält.

11. Kombination nach Anspruch 10, wobei die Erfassungsvorrichtung parallel zur Längsachse des Leistungsschalters oder des Polteils des Vakuumleistungsschalters positioniert ist.

## Revendications

1. Dispositif de détection pour un dispositif de commutation basse tension, moyenne tension ou haute tension, pour une connexion à une borne d'un tel dispositif de commutation et à un potentiel de terre, le dispositif de commutation comprenant :
une première partie de détection de tension (12) ; et
une deuxième partie de détection de tension (14) ;
une partie de détection de courant (13) étant agencée avec la première partie de détection de tension et la deuxième partie de détection de tension dans un unique boîtier (30) de dispositif de détection commun,
une extrémité de la première partie de détection de tension, une extrémité de la deuxième partie de détection de tension et un blindage électrique de la partie de détection de courant (13) étant connectés à une borne de terre (20) ;
une sortie (16) de la première partie de détection de tension (12) pour détecter une tension au niveau d'une borne supérieure (10) du dispositif de commutation s'étendant dans le boîtier (30) de dispositif de détection et étant isolée de la partie de détection de courant (13) ;
une sortie (18) de la deuxième partie de détection de tension (14) pour détecter une tension au niveau d'une borne inférieure (11) du dispositif de commutation s'étendant dans le boîtier (30) de dispositif de détection ;
la sortie (16) de la première partie de détection de tension (12), la sortie (18) de la deuxième partie de détection de tension (14) et une sortie (19) de la partie de détection de courant (13) étant isolées les unes des autres ; et
le dispositif de commutation et le dispositif de détection comprenant différents dispositifs, **caractérisé en ce que** le boîtier (30) de dispositif de détection est séparé d'un boîtier pour le dispositif de commutation.

2. Dispositif de détection selon la revendication 1, la deuxième partie de détection de tension étant située entre la partie de détection de courant et une connexion pour une borne inférieure du dispositif de commutation.

3. Dispositif de détection selon la revendication 1, la deuxième partie de détection de tension étant située en parallèle de la partie de détection de courant, pour une connexion entre une borne inférieure et un potentiel de terre du dispositif de commutation.

4. Dispositif de détection selon l'une quelconque des revendications 1 à 3, au moins la première des parties de détection de tension, située au niveau de la borne supérieure étant un diviseur résistif.

5. Dispositif de détection selon la revendication 1, la première partie de détection de tension, située au niveau de la borne supérieure étant munie de, ou agencée en tant qu'un diviseur résistif, et la deuxième partie de détection de tension située au niveau de la borne inférieure étant un diviseur résistif.

6. Dispositif de détection selon l'une quelconque des revendications 1 à 5, comprenant :
des technologies de détection de courant et de tension basse puissance en tant que parties de détection de courant et de tension.

7. Dispositif de détection selon l'une quelconque des revendications 1 à 5, comprenant :
un transformateur de courant pour une partie de détection de courant et/ou un transformateur de tension pour au moins une partie de détection de courant.

8. Dispositif de détection selon l'une quelconque des revendications 1 à 5, le dispositif de détection étant configuré pour une détection monophasée.

9. Dispositif de détection configuré pour une détection triphasée, chaque phase étant munie d'un dispositif de détection indépendant selon la revendication 1.

10. Dispositif de détection selon l'une quelconque des revendications 1 à 9, en combinaison avec un appareillage de connexion, avec un disjoncteur ou avec un disjoncteur à vide, le dispositif de détection étant positionné à proximité d'une partie formant poteau qui contient le disjoncteur ou le disjoncteur à vide.

11. Combinaison selon la revendication 10, le dispositif de détection étant positionné en parallèle de l'axe long de partie formant poteau à disjoncteur ou à disjoncteur à vide.
